# EUROPÄISCHE PATENTSCHRIFT

(11) **EP 1 555 133 B1**
(45) Veröffentlichungstag und Bekanntmachung des Hinweises auf die Patenterteilung: **23.03.2016**
(21) Anmeldenummer: 05000365.6
(22) Anmeldetag: 11.01.2005
(51) Int. Cl.: B41J 3/54, B41F 13/46

(54) **Einrichtung zur Erzeugung einer Beschichtung von Druckprodukten einer Druckmaschine**
Equipment of a printing machine for coating a printed product
Équipement d'une machine d'impression pour revêtir un produit imprimé

(30) Priorität: 15.01.2004 DE 102004002132
(43) Veröffentlichungstag der Anmeldung: 20.07.2005
(73) Patentinhaber: manroland web systems GmbH, 86153 Augsburg (DE)
(72) Erfinder: Schneider, Josef, 86420 Diedorf (DE); Schönert, Michael, 86150 Augsburg (DE); Stamme, Rainer, 86179 Augsburg (DE)

(56) Entgegenhaltungen:
- EP-A- 0 680 832
- EP-A- 1 008 449
- EP-A- 1 186 439
- EP-A1- 0 925 922
- WO-A-2004/106073
- US-A- 5 223 853
- US-A- 5 906 156
- US-A- 6 039 356
- US-A1- 2001 042 472
- US-A1- 2004 189 774
- US-B1- 6 193 348
- US-B1- 6 454 405

## Beschreibung

Die Erfindung betrifft eine Anordnung zum Drucken von gedruckten Druckerzeugnissen auf einen Bedruckstoff.

Rotationsdruckmaschinen mit Lackiereinrichtungen und diesen nachgeordneten Trocknern, in denen der in den Lackiereinrichtungen lackierte Bedruckstoff getrocknet wird, sind aus dem Stand der Technik bekannt. So werden beispielsweise bei Bogenrotations-Offsetdruckmaschinen die in den Druckwerken bedruckten Bogen in einem den Druckwerken nachgeschalteten Lackierwerk mit einer Lackschicht überzogen und die Bogen anschließend an einer bekannten Trocknereinrichtung in Form eines IR-, Heißluft- oder UV-Trockners vorbeigeführt, in der die lackierten Bogen vor der Ablage auf einem Auslegerstapel getrocknet werden.

Bekannte Lackierwerke haben die Aufgabe, die Scheuerfestigkeit und den Glanz von Druckerzeugnissen zu erhöhen bzw. bei extrem dünnen Lackauftrag das Ablegen der Farbe im Stapel zu vermeiden. Das Lackieren erfolgt in der Regel in den letzten Druckwerken.

Der einfachste Weg einer Drucklackierung kann über ein freies Farbwerk beschritten werden. Dabei wird bekanntlich ein spezieller Heatset-Lack eingesetzt, der wie eine normale Heatset-Farbe verarbeitet werden kann und nass-in-nass mit der Druckfarbe auf die Oberfläche des Papier übertragen und auch in Heatset-Trocknern getrocknet werden.

Um den auch im Rollenoffsetdruck zunehmenden Qualitätsanspruch zu entsprechen, werden auch spezielle Lackierwerke angeboten. Sie werden zwischen dem letzten Druckwerk und dem Heatset-Trockner positioniert.

Damit besteht die Möglichkeit, Lackierungen mit wässrigen Dispersionslacken vorzunehmen. Die Trocknung der meisten Dispersionslacke erfolgt rein physikalisch durch Verdunsten des Wassers. Mit einer speziellen UV-Trocknungsanlage (UV-Strahler) besteht im Rollenoffsetdruck auch die Möglichkeit, nicht nur die Trocknung der Druckfarbe sondern auch eine partielle UV-Lackierung vorzunehmen. Zur Verwendung kommen spezielle UV-Lacke, die auf 100% polymerisierbaren Bindemittelbestandteile aufgebracht sind.

Andererseits ist die Ink-Jet-Technologie nach dem Stand der Technik sowohl in privaten Bereichen (PC-Drucker im Heimbereich) als auch in industriellen Bereichen (digitale Proofsysteme, die direkt den Datenbestand der EDV nutzen /Digital-Drucker) weit verbreitet.

Im Home- und Office-Bereich sind vielfältige Drucker-Hersteller bekannt, die hochwertige und mehrfarbige Drucke mit z.T. sehr hoher Druckqualität (> 1200 dpi) herstellen können. Diese Drucker sind in der Regel für die Bedürfnisse privater Anwender ausgelegt, d.h. diese Drucker sind variabel einsetzbar hinsichtlich der einsetzbaren Bedruckstoffe und der Ansteuerung mittels PC. Nachteilig sind in der Regel die langsamen Druckgeschwindigkeiten (geringe Anzahl von Druckexemplaren pro Zeiteinheit) und die relativ hohen Kosten für die einzusetzenden Drucktinten. Für industrielle Anwendungen sind diese Ink-Jet-Drucker nicht geeignet.

Für die Bereiche der Druckindustrie gibt es ebenfalls vorhandene Ink-Jet-Drucksysteme. Es werden Ink-Jet-Systeme zur Herstellung von Andruckersatz (Proofs), zur Bebilderung von Druckplatten bzw. Druckformen oder explizit für den Digitaldruck von kleinen speziellen Auflagen (z.B. Körperformendruck) und spezielle Formate (z.B. großformatige Plakate oder Textilien) eingesetzt. Ähnlich wie beim privaten Einsatz des Ink-Jet-Drucks, gilt auch für den industriellen Einsatz, dass Ink-Jet-Drucksysteme vorwiegend für sehr kleine Druckauflagen genutzt werden und dass die Kosten für Drucktinten sehr hoch sind. Im Vergleich zu konventionellen Druckverfahren wie Offset und Tiefdruck, ist der Ink-Jet-Druck für den Auflagendruck nicht wirtschaftlich, da dieser bei hohen Druckauflösungen (> 1200 dpi) sehr langsam ist. Bei niedrigen Druckauflösungen (< 300 dpi) ist der Ink-Jet-Druck in der Lage, höhere Druckauflagen pro Zeiteinheit zu schaffen, jedoch auf Kosten einer ausreichenden Druckqualität.

Bisher erfolgt eine Beschichtung, Lackierung bzw. Veredelung von konventionell gedruckten Druckerzeugnissen (z.B. Offset oder Tiefdruck) oder von Digitaldruckerzeugnissen (z.B. photoelektrischer Druck) wie eingangs beschrieben durch konventionelle Beschichtungs-, Lackierungs- bzw. Veredelungsverfahren. Dies können Verfahren des Flexodrucks, des Tiefdrucks oder des Offsetdrucks sein. Es gibt weiterhin Beschichtungsverfahren, die mittels Kaschieren bzw. Laminieren (z.B. Aufkleben von Folien oder anderen Trägermaterialien) vorgenommen werden. Diese Verfahren werden ebenfalls überwiegend zur Veredelung und zum Oberflächenschutz der gedruckten Erzeugnisse eingesetzt.

Bei der Lackierung von Druckerzeugnissen kommen wie ebenfalls eingangs erwähnt zum größten Teil Wasserlacke oder UV-Lacke zum Einsatz. Die Lackierungen können ganzflächig oder nur auf Teilflächen vorgenommen werden. Dabei eignen sich konventionelle Beschichtungsverfahren besonders für hohe Druckauflagen und für hohe Qualitätsansprüche.

Die US 5 906 156 A offenbart eine Anordnung zum Drucken von gedruckten Druckerzeugnissen auf einen Bedruckstoff mit einem Rollenabwickler, einer Rollendruckmaschine, und mit einer Einrichtung zur Erzeugung einer Beschichtung, die eine Lackiereinheit in Form eines Ink-Jet-Druckers aufweist, und mit einem Falzapparat. Ink-Jet-Köpfe des Ink-Jet-Druckers bilden ein Ink-Jet-Kopf-Array, wobei die Ink-Jet-Köpfe in einer Reihe von ersten Ink-Jet-Köpfen sowie in einer Reihe von zweiten Ink-Jet-Köpfen angeordnet sind.

Aus der WO 2004/106073 A ist eine Einrichtung zur Erzeugung einer Beschichtung, nämlich einer Lackierung, auf einem Bedruckstoff bekannt, wobei die Lackiereinheit als Ink-Jet-Drucker ausgebildet ist. Ink-Jet-Köpfe des Ink-Jet-Druckers sind über eine Steuerungseinrichtung derart ansteuerbar, dass die Mengenverteilung des Beschichtungsmaterials sowohl in der Fläche als auch im Schichtprofil und damit in der Beschichtungsstärke variierbar ist.

Weiterer Stand der Technik ist aus der US 2004/189774 A1, der US 6 454 405 B1, der EP 0 680 832 A sowie der EP 1 008 449 A bekannt.

Die Aufgabe der Erfindung besteht in der Schaffung einer neuartigen Anordnung zum Drucken von gedruckten Druckerzeugnissen auf einen Bedruckstoff, die ein variabel gestaltbares Bedrucken des Bedruckstoffs bei hoher Druckqualität erlaubt.

Erfindungsgemäß wird die Aufgabe durch die Merkmale des Anspruchs 1 gelöst.

Ink-Jet-Druck ist eine Drucktechnologie, die in die Kategorie der Non-Impact-Drucker gehört. Man versteht darunter ein berührungsloses Druckverfahren, bei dem eine winzige Menge Tinte aus einer oder mehreren, extrem kleinen Düsen elektronisch gesteuert (wie bspw. in der DE 27 04 514 C2 beschrieben ist) auf den Bedruckstoff geschossen wird. Die Tintenstrahl-Drucktechniken werden untergliedert in "Continuous Jet" und "Drop on demand". Der Vorteil von berührungslosen Druckverfahren besteht darin, dass vorgelagerte Trocknungsverfahren im Bedarfsfall entfallen können, wodurch Kostenaufwendungen für Energie und Material eingespart werden könnten.

Desweiteren kann das Ink-Jet-Durckverfahren wie bereits erwähnt digital über sogenannte Druckbilddaten angesteuert werden. Somit wäre das Druckbild bzw. das Beschichtungsmotiv variabel gestaltbar. Bei konventionellen Beschichtungsverfahren (z.B. Flexodruck, Tiefdruck oder Laminierverfahren) ist das Motiv zur Beschichtung fest vorgegeben und somit nicht variabel. Ist ein Motiv einmal festgelegt, dann ist es als sogenannte Masterform nicht veränderbar. Solche konventionellen Masterformen sind in der Regel sehr teuer und nur auf einen speziellen Druck- bzw. Beschichtungsauftrag festgelegt. Für kleine Losgrößen und häufig wechselnde Druck- bzw. Beschichtungsaufträge ist der Einsatz von konventionellen Masterformen oft nicht wirtschaftlich, da in Bezug auf die geringe Losgröße die einmaligen Kosten für die Formen sehr hoch sind. Kleinere und spezielle Druckauflagen (z.B. personalisierte bzw. individualisierte Druckaufträge) sind charakteristisch für den Digitaldruck. Dabei hat sich ein Druckauflagenspektrum zwischen 10 bis 500 Exemplaren als mehrheitliche Auflagenhöhe für den Digitaldruck herausgebildet. Eine weitere wesentliche Anforderung an den Digitaldruck sind die kurzen Produktionszeiten, d.h. die Zeit für die Umsetzung von Druckprodukten reduziert sich gegenüber konventionellen Druckprozessen sehr stark. Die langen Herstellzeiten für spezielle konventionelle Beschichtungsformen sind für den Digitaldruck nicht zu rechtfertigen.

Somit eignet sich das Ink-Jet-Beschichtungsverfahren speziell für den Digitaldruck in jeder Ausprägung und für jedes Druckverfahren. D.h., vorliegende Erfindung kann in vorteilhafter Weise sowohl in jeder Rotationsdruckmaschine als auch in digitalen, bilddatenorientierten Druckmaschinen, insbesondere Ink-Jet-Druckmaschinen angewendet werden.

Das Ink-Jet-Druckverfahren benötigt keine Masterform, um einen Druck bzw. eine Beschichtung vorzunehmen. Die Ink-Jet-Düsen können variabel mittels digitaler Daten angesteuert werden, so dass ein Motiv zur Beschichtung flexibel und auf Anforderung (On-Demand) gewechselt werden kann. Das Wechseln der Druck- bzw. Beschichtungsmotive kann mit dem Ink-Jet-Druckverfahren "Online", d.h. in direkter Interaktion mit einer Steuereinheit ohne Zeitverlust durch Wechseln irgendwelcher Formen, vorgenommen werden. Es entstehen keine Kosten für die Herstellung und den Austausch von Formen zum Druck oder zur Beschichtung.

Weitere Vorteile durch den Einsatz des Ink-Jet-Druckverfahrens für den Druck bzw. die Beschichtung entstehen durch die Fähigkeit des Ink-Jets zur variablen Mengenverteilung von liquiden Beschichtungsmaterialien (z.B. Lack).

Neben einer variablen motivbezogenen Verteilung auf den zu beschichtenden Substraten, lässt sich mittels digitaler Bilddaten durch den Ink-Jet auch die quantitative Mengenverteilung variieren. Mit dieser zusätzlichen Eigenschaft können sogenannte Schichtprofile mit unterschiedlichen Beschichtungsstärken erzielt werden. Es lassen sich zum Beispiel Beschichtungen nach Schriften, Bildern und Hintergründen nicht nur vom Motiv differenzieren, sondern diese können auch im Profil unterschieden werden. Somit ergeben sich erweiterte Nutzen durch Beschichtungen mittels Ink-Jet neben den eigentlichen Funktionen (Oberflächenschutz und Glanz) auch für die Anmutung und Ästhetik von Druckprodukten.

Durch die in dieser Erfindung dargestellten Ink-Jet-Beschichtungsmethode lassen sich neben Lacken zur schützenden (z.B. Abriebschutz) und veredelnden Wirkung (z.B. Glanz) auch Sonderfarben (z.B. Leuchtfarben) oder Funktionsmaterialien (z.B. polymerelektronische Materialien für elektrische Leitfunktionen) übertragen. Diese Sonderfarben bzw. Materialien können gemäß ihrer Funktion ganzflächig bzw. vorteilhaft partiell (z.B. Schriften, Codes, Zeichen) mittels Ink-Jet aufgebracht werden. Die Sonderfarben bzw. Funktionsmaterialien lassen sich z.B. im Sicherheitsbereich bzw. Verpackungsbereich für die Kennzeichnung von Produkten durch das Beschichten der Produkte selbst oder durch das Beschichten von Etiketten einsetzen.

Bei den Sonderfarben lassen sich zum Beispiel unsichtbare Tinten verdrucken, die nur unter UV-Licht sichtbar sind und somit Sicherheitsfunktionen erfüllen. Durch das Aufbringen von polymerelektronischen Materialien lassen sich leitfähige Elemente übertragen, die für Registrationsfunktionen dienen können.

Die Ink-Jet Druck- bzw. Beschichtungseinheit zur Beschichtung von Druckprodukten kann in bestehende Druckmaschinen oder in neu zu konzeptionierende Druckmaschinen integriert werden. Die zum Einsatz kommenden Druckmaschinen können sowohl Bogendruckmaschinen als auch Rollendruckmaschinen sein. Der Einsatz des Ink-Jet-Verfahrens zur Beschichtung von Druckprodukten ist unabhängig vom eingesetzten Druckverfahren mit denen die zu beschichtenden Druckprodukte hergestellt werden. Es können sowohl mittels konventioneller Druckverfahren (z.B. Offset-, Flexo- oder Tiefdruck) hergestellte Druckprodukte als auch mittels Digitaldruck (z.B. Photoelektrischer Druck, Xerographie) hergestellte Produkte beschichtet werden.

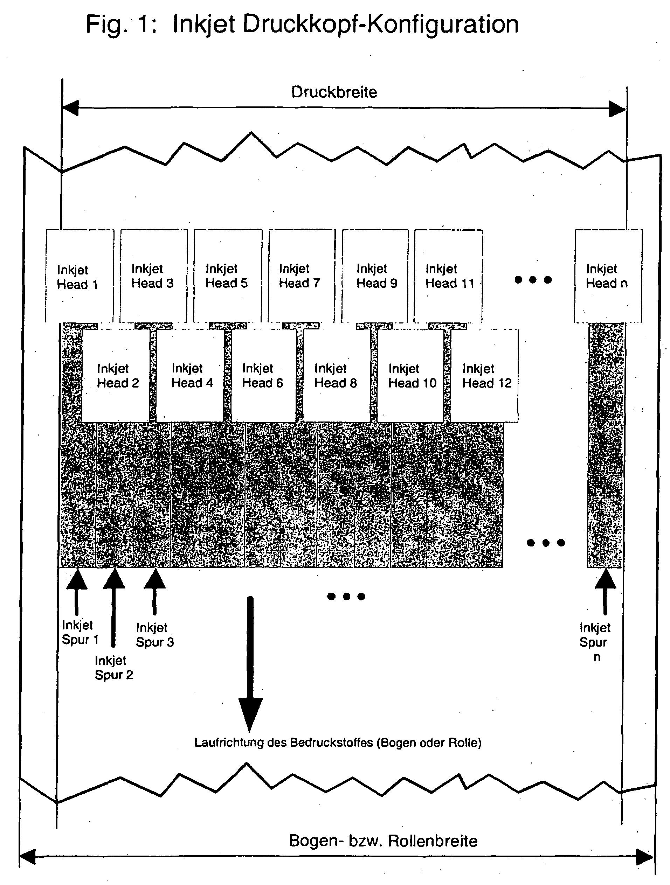

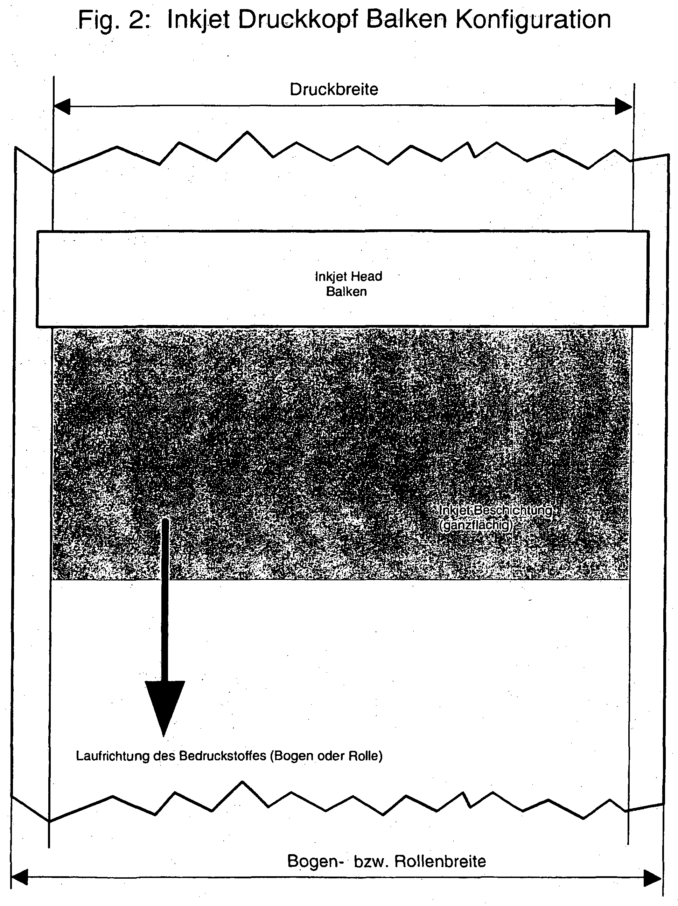

Die Anordnung der Ink-Jet-Beschichtungseinheit ist in Form eines Ink-Jet-Kopf-Arrays (Mehrkopf-Anordnung) (Fig. 1) ausgeführt. Eine nicht erfindungsgemäße Anordnung der Ink-Jet-Beschichtungseinheit in Form eines Ink-Jet-Kopf-Balkens zeigt Fig. 2.

Durch die Anordnung des Ink-Jet-Kopf-Arrays ist die komplette Abdeckung des zu beschichtenden Druckproduktes zu gewährleisten. Somit soll die gesamte Fläche des Druckproduktes beschichtet werden können. Das zu beschichtende Druckprodukt wird in der Anordnungskonfiguration unter den Austrittsöffnungen der Ink-Jet-Köpfe vorbeigeführt, so dass die Aufnahme und Beschichtung mit den liquiden Beschichtungsmaterialien (z.B. Lack) ermöglicht wird.

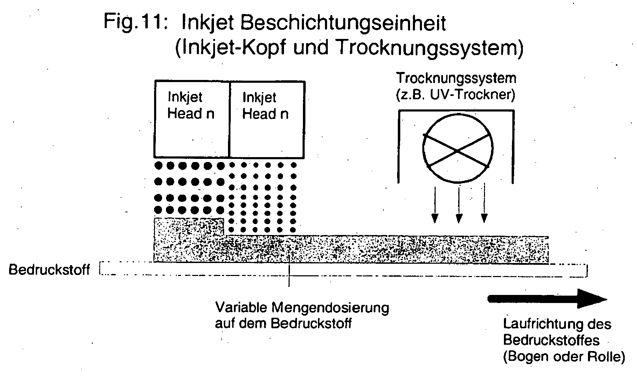

In bevorzugter Weise besteht die Ink-Jet-Beschichtungseinheit aus einer Kombination aus den Ink-Jet-Kopf-Arrays und einer Trocknungseinheit, die das liquide Beschichtungsmaterial (z.B. UV-Lack) auf dem Druckprodukt nach dem Auftrag trocknet (Fig. 11).

Diese Trocknung ermöglicht die Weiterbehandlung der beschichteten Druckprodukte. Diese Trocknungseinheit kann ein UV-Trockner sein, wenn als Beschichtungsmaterial z.B. UV-Lack eingesetzt wird. Die Trocknungseinheit muss auf das zum Einsatz kommende Beschichtungsmaterial abgestimmt sein bzw. zur Trocknung des liquiden Materials geeignet sein. Für den Einsatz von wässrigen Materialien wären z.B. Heißluft- und Infrarot-Trockner geeignet.

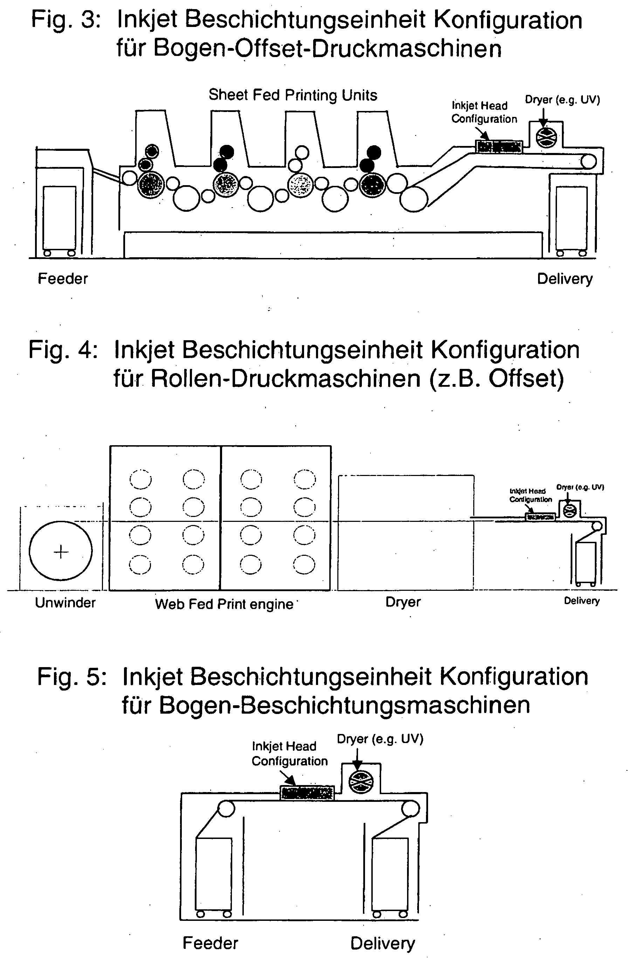

Fig. 3 zeigt eine nicht erfindungsgemäße Anordnung zum Drucken von gedruckten Druckerzeugnissen, bei der die Ink-Jet-Beschichtungseinheit in eine Bogen-Offset-Druckmaschinen integriert ist, wobei die Beschichtung beim Bogenauslauf am Ende der Bogendruckmaschine angeordnet sein sollte. (Fig. 3)

Die Ink-Jet-Beschichtungseinheit kann erfindungsgemäß in Rollen-Offset-Druckmaschinen integriert werden, wobei die Beschichtung beim Rollenauslauf am Ende der Rollendruckmaschine angeordnet ist. (Fig. 4)

Fig. 5 zeigt eine weitere nicht erfindungsgemäße Anordnung zum Drucken von gedruckten Druckerzeugnissen, bei der die Ink-Jet-Beschichtungseinheit in Bogen-Beschichtungsdruckmaschinen integriert ist, wobei die Beschichtung beim Bogenauslauf am Ende der Bogenmaschine angeordnet sein sollte. (Fig. 5)

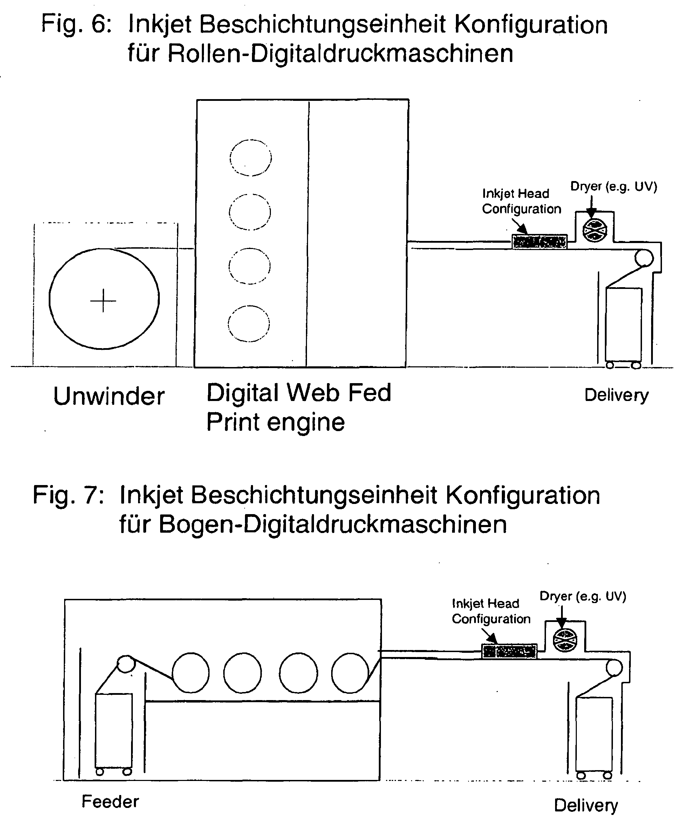

Diese Beschichtungsmaschine kann auf das Beschichten von Druckprodukten beschränkt sein, so dass diese Maschine z.B. nur Beschichtungen vornimmt. Die Ink-Jet-Beschichtungseinheit kann erfindungsgemäß in Rollen-Digital-Druckmaschinen integriert werden, wobei die Beschichtung beim Rollenauslauf am Ende der Rollen-Digitaldruckmaschine angeordnet ist. (Fig. 6)

Fig. 7 zeigt eine weitere nicht erfindungsgemäße Anordnung zum Drucken von gedruckten Druckerzeugnissen, bei der die Ink-Jet-Beschichtungseinheit in Bogen-Digital-Druckmaschinen integriert ist, wobei die Beschichtung beim Bogenauslauf am Ende der Bogen-Digitaldruckmaschine angeordnet sein sollte. (Fig. 7)

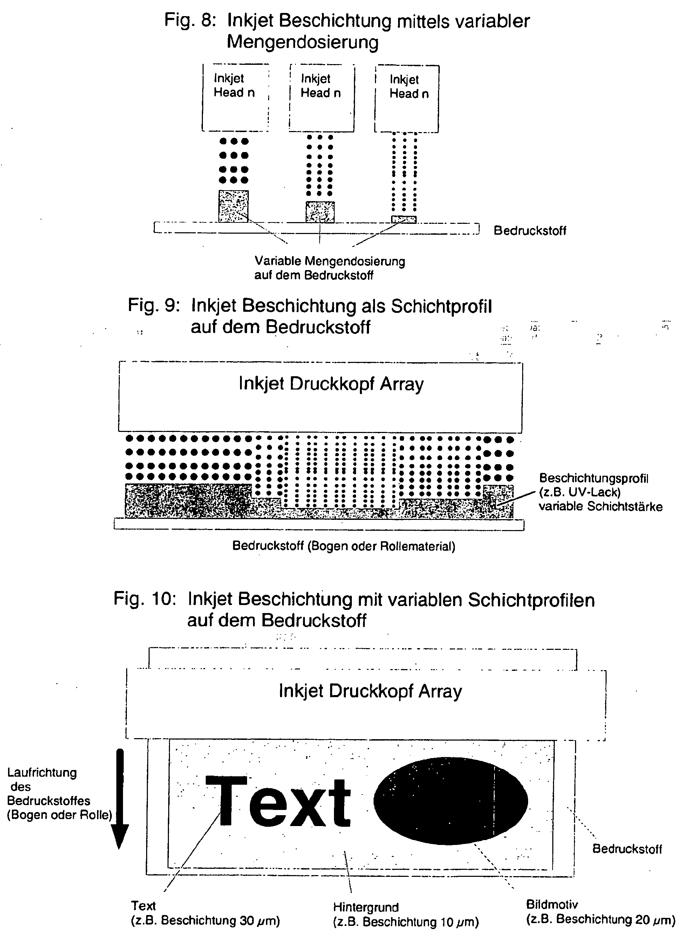

Die Ink-Jet-Köpfe lassen sich mittels digitaler Bilddaten über eine Steuerungseinheit (z.B. Bilddatenrechner) ansteuern. Die Verteilung des Beschichtungsmaterials (z.B. Lack) kann sowohl in der Fläche (z.B. Bildmotive, Schriften oder Hintergründe) (Fig. 10) als auch im Schichtprofil (z.B. Lackfilmdicke bzw. Schichtstärke des Mediums) variieren.

Die Tropfencharakteristik der Ink-Jet-Köpfe kann modifiziert werden. Das Beschichtungsergebnis kann sowohl eine volle Flächendeckung mit höchster Schichtstärke als auch das Ausbleiben jeglicher Beschichtung (z.B. kein Lackauftrag bzw. Spotcoating) sein. Die Verteilung des Beschichtungsmediums (z.B. Lack) kann beliebig stufenlos in der Fläche und als Schichtprofil verteilt werden (Fig. 8, Fig. 9).

## Patentansprüche

1. Anordnung zum Drucken von gedruckten Druckerzeugnissen auf einen Bedruckstoff, wobei dieselbe folgende Konfiguration aufweist:
Rollenabwickler (Unwinder);
Rollendruckmaschine (Web Fed Print engine), nämlich Rollen-Offset-Druckmaschine oder Rollen-Digital-Druckmaschine, wobei dann, wenn die Rollendruckmaschine als Rollen-Offset-Druckmaschine ausgebildet ist, derselben ein erster Trockner (Dryer) nachgeordnet ist;
Einrichtung zur Erzeugung einer Beschichtung, mit einer Lackiereinheit zum Beschichten eines in der Druckmaschine verarbeiteten Bedruckstoffs, wobei die Lackiereinheit als separater Ink-Jet-Drucker in Form eines Ink-Jet-Kopf-Arrays zum zeilenweisen Beaufschlagen des bevorzugt großformatigen Bedruckstoffs verwendet wird, wobei der Bedruckstoff unter Austrittsöffnungen der Ink-Jet-Köpfe durchgeführt wird, und wobei die Ink-Jet-Köpfe über eine Steuerungseinrichtung derart angesteuert sind, dass die Mengenverteilung des Beschichtungsmaterials sowohl in der Fläche als auch im Schichtprofil und damit in der Beschichtungsstärke variierbar ist, wobei;
das Ink-Jet-Kopf-Array als Mehrkopf-Anordnung aus mehreren Ink-Jet-Köpfen (Inkjet Head 1 bis Inkjet Head n) ausgebildet ist, wobei jeder Ink-Jet-Kopf (Inkjet Head 1 bis Inkjet Head n) mehrere nebeneinander angeordnete Austrittsöffnungen in Form von Ink-Jet-Düsen aufweist, wobei die Ink-Jet-Köpfe in einer ersten Reihe von ersten Ink-Jet-Köpfen (Inkjet Head 1 bis Inkjet Head n) sowie in einer zur ersten Reihe parallelen zweiten Reihe von zweiten Ink-Jet-Köpfen (Inkjet Head 2 bis Inkjet Head 12) angeordnet sind, wobei die zweiten Ink-Jet-Köpfe Köpfe (Inkjet Head 2 bis Inkjet Head 12) gegen die ersten Ink-Jet-Köpfe (Inkjet Head 1 bis Inkjet Head n) in Richtung der zweiten Reihe derart versetzt sind, dass die ersten und zweiten Ink-Jet-Köpfe nebeneinander liegende Inkjet Spuren (Inkjet Spur 1 bis Inkjet Spur n) zur kompletten Abdeckung des zu beschichtenden Druckprodukts erzeugen;
die Ink-Jet-Köpfe des Ink-Jet-Kopf-Arrays mit einem Bilddatenrechner datentechnisch verbunden sind, wobei der Bilddatenrechner als Steuerungseinheit für die Ink-Jet-Köpfe derart ausgebildet ist, dass die Tropfencharakteristik der Ink-Jet-Köpfe mittels digitaler Bilddaten derart modifizierbar ist, dass die Mengenverteilung des Beschichtungsmaterials zwischen einer vollen Flächendeckung mit höchster Schichtdicke und dem Ausbleiben jeglicher Beschichtung stufenlos variierbar ist;
wobei die Einrichtung zur Erzeugung der Beschichtung bei einem Rollenauslauf am Ende der Rollendruckmaschine angeordnet ist;
zweiter Trockner (Dryer), wobei der zweite Trockner in Transportrichtung des Bedruckstoffs gesehen unmittelbar nach der Einrichtung zur Erzeugung der Beschichtung angeordnet ist, um das liquide Beschichtungsmaterial auf dem Bedruckstoff nach dem Auftrag zu trocknen.

2. Anordnung nach Anspruch 1, **dadurch gekennzeichnet, dass** die Ink-Jet-Köpfe mittels digitaler Bilddaten über die Steuerungseinheit außerdem derart angesteuert sind, dass die Verteilung des Beschichtungsmaterials derart in der Fläche variierbar ist, dass mittels der digitalen Bilddaten eine variable Verteilung bezogen auf Motive (Text, Hintergrund, Bildmotiv) auf dem Bedruckstoff erfolgt.

3. Anordnung nach Anspruch 1 oder 2, **dadurch gekennzeichnet, dass** bei Verwendung von UV-Lack als Beschichtungsmaterial als zweiter Trockner ein UV-Trockner verwendet wird.

4. Anordnung nach Anspruch 1 oder 2, **dadurch gekennzeichnet, dass** bei Verwendung von wässrigen Materialien als Beschichtungsmaterial als zweiter Trockner ein Heißluft- oder Infrarot- Trockner

## Claims

1. An arrangement for printing printed products on a printing substrate, wherein the latter has the following configuration:
unwinder;
web-fed printing machine (web fed print engine), i.e. web-fed offset printing machine or web-fed digital printing machine, wherein, when the web-fed printing machine is constituted as a web-fed offset printing machine, a first dryer is disposed downstream of the latter;
a device for producing a coating, comprising a varnishing unit for coating a printing substrate processed in the printing machine, wherein the varnishing unit is used as a separate inkjet printer in the form of an inkjet head array for the line-by-line application to the preferably large-format printing substrate, wherein a printing substrate is passed through beneath the outlet openings of the inkjet heads, and wherein the inkjet heads are controlled by a control device, in such a way that the quantity distribution of the coating material can be varied both in the area as well as in the layer profile and therefore in the coating thickness, wherein
the inkjet head array is constituted as a multi-head arrangement comprising a plurality of inkjet heads (inkjet head 1 to inkjet head n), wherein each inkjet head (inkjet head 1 to inkjet head n) comprises a plurality of outlet openings in the form of inkjet nozzles disposed beside one another, wherein the inkjet heads are disposed in a first row of first inkjet heads (inkjet head 1 to inkjet head n) and in a second row of second inkjet heads (inkjet head 2 to inkjet head 12) parallel to the first row, wherein the second inkjet heads (inkjet head 2 to inkjet head 12) are offset against the first inkjet heads (inkjet head 1 to inkjet head n) in the direction of the second row, in such a way that the first and second inkjet heads produce inkjet tracks lying beside one another (inkjet track 1 to inkjet track n) for the complete coverage of the printed product to be coated;
the inkjet heads of the inkjet head array are connected for data transmission to an image data computer, wherein the image data computer is constituted as a control unit for the inkjet heads, in such a way that the drop characteristic of the inkjet heads can be modified by means of digital image data, such that the quantity distribution of the coating material can be varied continuously between a full area coverage with maximum layer thickness and the absence of any coating;
wherein the device for producing the coating is disposed at a web exit at the end of the web-fed printing machine;
a second dryer, wherein the second dryer is disposed, viewed in the transport direction of the printing substrate, directly after the device for producing the coating, in order to dry the liquid coating material on the printing substrate after the deposition.

2. The arrangement according to claim 1, **characterised in that** the inkjet heads are controlled by means of digital image data by the control unit, in such a way that the distribution of the coating material can be varied in the area, such that a variable distribution in respect of patterns (text, background, image pattern) takes place on the printing substrate by means of the digital image data.

3. The arrangement according to claim 1 or 2, **characterised in that** a UV dryer is used as the second dryer when use is made of UV varnish as a coating material.

4. The arrangement according to claim 1 or 2, **characterised in that** a hot-air or infrared dryer is used as the second dryer when use is made of aqueous materials as a coating material.

## Revendications

1. Dispositif d'impression de produits d'impression imprimés sur un support d'impression, lequel dispositif présente la configuration suivante :
dérouleur de rouleaux (unwinder);
presse rotative (web fed print engine), à savoir machine d'impression offset à rouleaux ou machine d'impression numérique à rouleaux, sachant que, lorsque la presse rotative se présente sous forme d'une machine d'impression offset à rouleaux, un premier sécheur (dryer) est installé en aval de celle-ci ;
dispositif de création d'un revêtement, comportant une unité de vernissage pour le revêtement d'un support d'impression traité dans la machine d'impression, l'unité de vernissage étant utilisée sous forme d'une imprimante à jet d'encre séparée ayant la forme d'un réseau de têtes de jet d'encre pour solliciter par lignes le support d'impression de préférence de grand format, le support d'impression étant passé sous des orifices de sortie des têtes à jet d'encre et les têtes à jet d'encre étant commandées par un dispositif de commande de manière à ce que la répartition quantitative du matériau de revêtement soit variable aussi bien au niveau de la surface que dans le profil des couches et ainsi dans l'épaisseur du revêtement ;
le réseau de tête à jet d'encre étant réalisé sous forme d'un dispositif à têtes multiples composé de plusieurs têtes à jet d'encre (tête à jet d'encre 1 à tête à jet d'encre n), chaque tête à jet d'encre (tête à jet d'encre 1 à tête à jet d'encre n) présentant plusieurs orifices de sortie juxtaposés sous forme de buses à jet d'encre, les têtes à jet d'encre étant disposées dans une première rangée depuis des premières têtes à jet d'encre (tête à jet d'encre 1 à tête à jet d'encre n) et dans une seconde rangée de seconde têtes à jet d'encre (tête à jet d'encre 2 à tête à jet d'encre 12) parallèle à la première rangée, les secondes têtes à jet d'encre (tête à jet d'encre 2 à tête à jet d'encre 12) étant décalées par rapport aux premières têtes à jet d'encre (tête à jet d'encre 1 à tête à jet d'encre n) en direction de la seconde rangée de manière à ce que les premières et secondes têtes à jet d'encre créent des pistes de jet d'encre juxtaposées (piste de jet d'encre 1 à piste de jet d'encre n) pour recouvrir complètement le produit d'impression à revêtir ;
les têtes à jet d'encre du réseau de têtes à jet d'encre sont reliées au niveau technologie de données à un calculateur de données graphiques, le calculateur de données graphiques étant réalisé sous forme d'une unité de commande pour les têtes à jet d'encre de manière à ce que la caractéristique de d'égouttage des têtes à jet d'encre soit modifiable au moyen de données graphiques numériques de manière à ce que la répartition quantitative du matériau de revêtement soit variable graduellement entre un recouvrement total de la surface avec une épaisseur de couche maximale et l'omission de tout revêtement ;
le dispositif de création du revêtement étant disposé à une sortie de rouleaux à l'extrémité de la presse rotative ;
second sécheur (dryer), le second sécheur étant disposé, vu dans le sens de transport du support d'impression, directement en aval du dispositif de création du revêtement afin de sécher le matériau de revêtement liquide sur le support d'impression après application.

2. Dispositif selon la revendication 1, **caractérisé en ce que** les têtes à jet d'encre sont en outre commandées au moyen de données graphiques numériques par l'unité de commande de manière à ce que la répartition du matériau de revêtement soit variable dans la surface de sorte qu'une répartition variable au niveau des motifs (texte, arrière-plan, motif graphique) soit effectuée sur le support d'impression au moyen des données graphiques numériques.

3. Dispositif selon la revendication 1 ou 2, **caractérisé en ce que**, en cas d'utilisation de vernis UV comme matériau de revêtement, on utilise un sécheur UV comme second sécheur.

4. Dispositif selon la revendication 1 ou 2, **caractérisé en ce que**, en cas d'utilisation de matières aqueuses comme matériau de revêtement, on utilise un sécheur à air chaud ou à infrarouges comme second retour sécheur.
